Europäisches Patentamt

European Patent Office

Office européen des brevets

(11) Publication number: **0 205 223**
**B1**

(19)

## EUROPEAN PATENT SPECIFICATION

(12)

(45) Date of publication of the patent specification:
**13.12.89**

(51) Int. Cl.⁴: **G01N 24/08**

(21) Application number: **86201017.0**

(22) Date of filing: **11.06.86**

(54) Magnetic resonance imaging method utilizing small excitation pulses.

(30) Priority: **12.06.85 NL 8501685**
**14.08.85 NL 8502249**

(43) Date of publication of application:
**17.12.86 Bulletin 86/51**

(45) Publication of the grant of the patent:
**13.12.89 Bulletin 89/50**

(84) Designated Contracting States:
**BE DE FR GB IT NL SE**

(56) References cited:
**EP-A- 0 055 058**
**EP-A- 0 091 008**
**EP-A- 0 103 397**
**EP-A- 0 137 420**
**US-A- 4 319 190**

"A new look at the method of variable nutation angle for the measurement of spin-lattice relaxation times using fourier tranform NMR", Journal of magnetic resonance 25, pp. 231-235, 1977
Fourier transform study of NMR spin-lattice relaxation by "Progressive Saturation", The Journal of Chemical Physics", vol. 54, no. 8, pp. 3367-3377, April 1971

(73) Proprietor: **N.V. Philips' Gloeilampenfabrieken,**
**Groenewoudseweg 1, NL-5621 BA Eindhoven(NL)**

(72) Inventor: **van der Meulen, Peter, c/o INT.**
**OCTROOIBUREAU B.V. Prof. Holstlaan 6, NL-5656 AA Eindhoven(NL)**
Inventor: **Groen, Johannes Petrus, c/o INT.**
**OCTROOIBUREAU B.V. Prof. Holstlaan 6, NL-5656 AA Eindhoven(NL)**
Inventor: **Cuppen, Johannes Josephus Maria, c/o INT.**
**OCTROOIBUREAU B.V. Prof. Holstlaan 6, NL-5656 AA Eindhoven(NL)**

(74) Representative: **Zwaan, Andries Willem et al,**
**INTERNATIONAAL OCTROOIBUREAU B.V. Prof. Holstlaan 6, NL-5656 AA Eindhoven(NL)**

## Description

The invention relates to a method of determining a nuclear magnetization distribution in a region of a body which is situated in a generated, steady, uniform magnetic field, which method comprises measurement cycles including the steps a), b), c) and d)

a) influencing spin nuclei in the selected region of the body by means of high-frequency electromagnetic pulses,

b) applying a preparatory magnetic field gradient during a preparation period,

c) rephasing the spin nuclei by means of a magnetic field gradient which has been inverted with respect to the magnetic field gradient applied during the preparation period,

d) sampling the resonance signal during a measurement period

e) repeating measurement cycles including the steps a), b), c) and d) each time with a different value of the time integral of the magnetic field gradient specified in paragraph b).

Such a method is known from the European Patent Application Nr. 0 103 397.

Devices for determining a nuclear magnetization distribution in a region of a body and the principles on which the operation of such devices is based are known, for example from the article "Proton NMR tomography" in Philips Technical Review, Volume 41, 1983/1984, no. 3, pages 73–88. Reference is made to this article for the description of the construction and principles.

In a method described in EP 0 103 397 a body to be examined is exposed to a strong, steady, uniform magnetic field Bo whose direction coincides with, for example the z-axis of a cartesian (x, y, z) coordinate system. The steady magnetic field Bo causes a slight polarization of the spin nuclei to perform a precessional motion about the direction of the magnetic field Bo. After application of the magnetic field Bo a magnetic field gradient which acts as a selection gradient is applied and at the same time a 90° r.f. pulse is generated which rotates the magnetization direction of the nuclei present in the selected slice through an angle 90°. After termination of the 90° pulse, the spin nuclei will perform a precessional motion about the field direction of the magnetic field Bo, thus generating a resonance signal (FID signal). After the 90° pulse, there are simultaneously applied field gradients $G_y$, $G_x$ and $G_z$ whose field direction coincides with that of the magnetic field Bo and whose gradient directions extend in the y, the x and the z direction, respectively. The field gradients $G_x$, $G_y$ and $G_z$ serve for rephasing and coding the spin nuclei in the x, the y and the z direction, respectively. After termination of these three field gradients an inverted field gradient $G_x$ is applied, an echo signal of the original FID signal then being sampled.

In order to obtain an image of a selected region, a measurement cycle is repeated a number of times with for each cycle a different value of the time integral of the field gradient $G_y$ and/or $G_z$. By arranging the Fourier transforms of the resonance signals according to increasing value of the time integral of the field gradient $G_y$ on the one hand and the field gradient $G_z$ on the other hand and by subjecting these values to a Fourier transformation in the y-direction and subsequently in the z-direction, a spin density distribution will be obtained as a function of x, y and z.

In accordance with the method disclosed in the Patent Application EP 0 103 397 e.g. information on the spin lattice or longitudinal relaxation time $T_1$ is obtained by preceding said measurement cycles by an initial step of inverting the spins followed by an interval approximately equal to the average relaxation time of the spins. This implies a relatively long total measurement time for obtaining a so-called $T_1$-image, apart from the fact that such an image will contain approximate $T_1$ information only.

It is the object of present invention to provide a method for fast and accurate determination of $T_1$-images.

A method of the kind set forth in accordance with the invention is characterized in that the high-frequency electromagnetic pulses are excitation pulses in the form of $\alpha°$ pulses where $0<\alpha<90°$, the successive measurement cycles being directly or substantially directly consecutive, and in that a longitudinal relaxation time $T_1$ per volume element is calculated from intensities of volume elements in images which differ either as regards the angle $\alpha$ and/or the repetition time $T_R$ between two successive $\alpha°$ pulses. Due to the fact that a high-frequency electromagnetic $\alpha°$ pulse is generated, where $0<\alpha<90$, the magnetization M will perform a precessional motion at an angle $\alpha$ about the direction of the uniform, steady magnetic field Bo, so that the resonance signal ultimately obtained will be proportional to the transversal component $M_t$ of the magnetization M. This transversal component will have disappeared some time after the resonance signal, because on the one hand a field gradient present during a measurement ensures further dephasing in the measurement direction and on the other hand the magnitude of this component is reduced by $T_2$ relaxation. The longitudinal component $M_l$ of the magnetization M, however, will meanwhile increase to its original magnitude due to $T_1$ relaxation. After termination of the measurement period, a similar measurement cycle can be repeated while utilizing only a very brief waiting period (in the order of magnitude of the measurement period) or even no waiting period. Under the influence of a second $\alpha°$ pulse, the longitudinal component $M_l$ of the magnetization M which originally performs a precessional motion at an angle $\alpha°$ about the direction of the steady, uniform magnetic field Bo under the influence of the first $\alpha°$ pulse, now performs a precessional motion at an angle $\alpha°$ about the same direction. The measurement signal ultimately obtained will be proportional to the transversal component of the originally longitudinal component $M_l$ of the magnetization M. E.g. a difference in excitation angle between the first and second $\alpha°$ pulse will provide implicit $T_1$ information. Due

to the fact no preceding inversion will be necessary (normally by means of a 180° inversion pulse) and due to the fact no cycle built-in and inter-cycle extra waiting time will be needed the method according to present invention will be very efficient.

It is to be noticed that the use of $\alpha°$ pulses is known per se from the European Patent Application 0 137 420. Therein spin nuclei are excited by an $\alpha°$ pulse, an echo resonance signal being generated by a first 180° pulse and longitudinal relaxation being rapidly returned along a positive z-axis by a second 180° pulse. This implies a relatively high r.f. load for a patient to be examined as well for the equipement. The resonance signals are sampled and an image depicting e.g. proton densities is formed by means of Fourier transformation. According to predetermined measurement parameters the image may be spin lattice ($T_1$) or spin–spin ($T_2$) weighted.

It is further noticed that a method for $T_1$-calculation is known in psectroscopy from the article "A New Look at the Method of Variable Nutation Angle for the Measurement of Spin-Lattice Relaxation times Using Fourier Transform NMR", Journal of Magnetic Resonance, pp. 231–235, 1977. The longitudinal relaxation time $T_1$ is calculated from a linear plot obtained by collecting a considerable number of data points varying a pulse angle $\alpha$ over a range, e.g. 10 data points and an $\alpha$ range of 20–110° (in steps of 10°), in a steady state sequence of $\alpha°$ pulses.

It is further noticed that a method for $T_1$-determination with variation of the repetition time $T_R$ is known in spectroscopy from the article "Fourier Transform Study of NMR Spin-Lattice Relaxation by "Progressive Saturation"", The Journal of Chemical Physics, Vol. 54, No. 8, pp. 3367–3377, April 1971. In said method a repetitive train of strong radiofrequency pulses is applied to a nuclear spin system, and a steady state established between excitation and relaxation between pulses. The pulse parameters being adjusted to the condition where the spin magnetization is nutated into the transversal plane, and all spin isochromats being destroyed before each pulse, the spin dynamics being determined by spin-lattice relaxation only. In said method it is recognized that the amplitude of a free precessional signal is directly proportional to the longitudinal component of magnetization that has recovered in an interval between pulses. The signal intensity is studied as a function of the pulse interval, the difference between thermal equilibrium magnetization and steady state free precession magnetization follows an exponential with a time constant equal to the spin-lattice relaxation time. So, said method consists of a series of measurements of signal amplitude at different settings of the pulse repetition rate, with at least one measurement at a pulse separation that is large compared with all spin-lattice relaxation times, to give the thermal equilibrium value. In present invention no thermal equilibrium value is used.

A preferred version is characterized in that the longitudinal relaxation time $T_1$ is calculated by means of the formula:

$Ip=[c.\sin(\alpha).(1-\exp(-T_R/T_1))]/[1-\cos(\alpha).\exp(-T_R/T_1)]$, in which Ip is the intensity of a volume element p, $\alpha$ is the angle $\alpha°$, $T_R$ is the repetition time, $T_1$ is the longitudinal relaxation time, and c is a constant which does not depend on $\alpha$, $T_R$ or $T_1$. When the intensities of volume elements in an image are measured from at least two cycles which differ as regards the angle $\alpha$ and/or the repetition time $T_R$, the longitudinal relaxation time $T_1$ per volume element can be calculated, using the above formula, from at least two equations with two unknowns (that is to say Ip, $\alpha$, $T_R$ are known, c and $T_1$ are unknown).

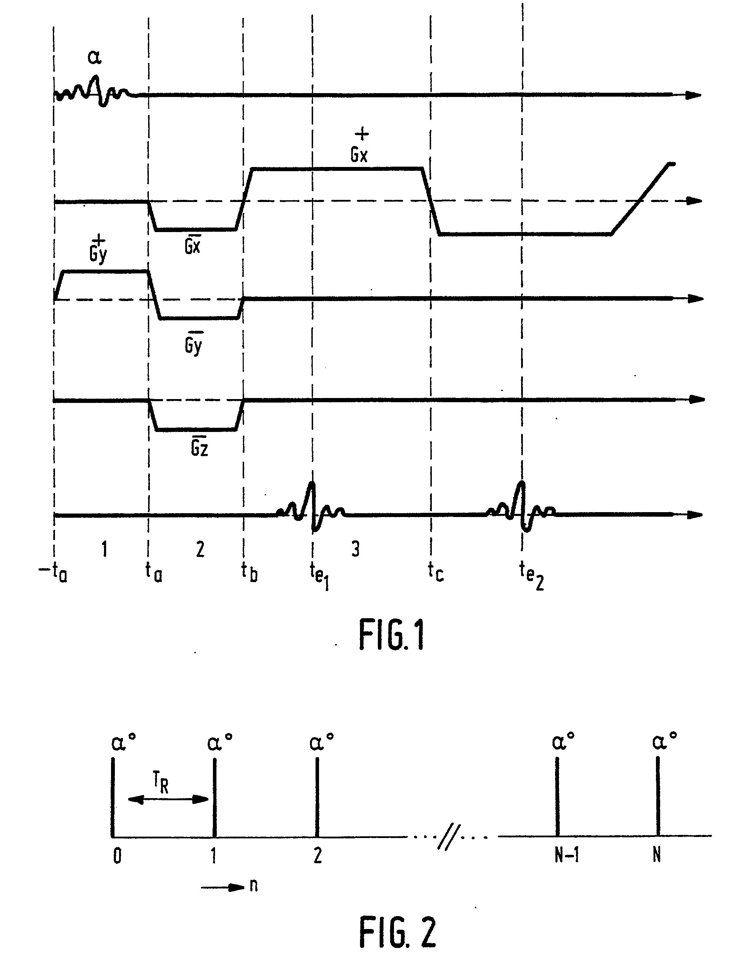

The invention will be described in detail hereinafter on the basis of a pulse sequence of an embodiment shown in figure 1, and a so-called $(\alpha°-T_R)_N$ pulse sequence shown in figure 2.

A convention orthogonal system of coordinates is considered in which a steady, uniform magnetic field Bo is directed along the z-axis and a high-frequency electromagnetic field is directed along the y-axis. Also provided are coils for producing $G_x$, $G_y$ and $G_z$ gradients in the x, the y and the z-direction, respectively. A patient is arranged in the horizontal position, the z-axis extending vertically and the y-axis extending horizontally with respect to the longitudinal direction of the patient. Hereinafter, a +, − notation, for example $G_y^+$, indicates whether the field direction of a field gradient is positive or negative, respectively.

During the interval 1 in fig. 1, bounded by the instant $t=-t_a$ and $t=t_a$, a magnetic field gradient $G_y^+$ is applied and at the same time a high-frequency electromagnetic $\alpha°$ pulse is generated. (In practice $\alpha$ lies between 20 and 80 degrees). Consequently, the spin nuclei are excited in the plane $Y=Y_0$, which means that the magnetization generated by the spin nuclei in the plane $Y=Y_0$ performs a precessional motion at an angle $\alpha°$ about the z-axis. Due to the bandwidth of the $\alpha°$ pulse, spin nuclei will be excited not only in the plane $Y=Y_0$, but also in the direct vicinity thereof. By variation of the frequency of the $\alpha°$ pulse, spin nuclei can be excited in any other plane parallel to the plane $Y=Y_0$.

During the interval 2, bounded by the instants $t=t_a$ and $t=t_b$, three magnetic field gradients $G_x^-$, $G_y^-$ and $G_z^\pm$ are applied. In order to save time, these three field gradients are applied during the same time interval. However, because no $\alpha°$ pulses are generated during this interval, the effects of the field gradient can be separately considered. The negative gradient $G_y^-$ rephase the spin nuclei in the y direction so that the spin nuclei which are selectively excited in and in the direct vicinity of the plane $Y=Y_0$ no longer experience phase discrimination in the y direction. Therefore an approximate rephasing condition holds good:

$$(1/2).\{Int(G_y^+dt)\}^{-t_a} \text{ to } t_a = \{Int(G_y^-dt)\}t_a \text{ to } t_b, \quad (1)$$

wherein Int the integrating operator is and $^{-t_a}$ to $t_a$ and $t_a$ to $t_b$ are integrating boundaries, respectively. (The factor (1/2) in the left-hand term compensates for the fact that the $\alpha°$ pulse acts effectively only halfway the interval bounded by the in-

stants $t=-t_a$ and $t=t_a$). Thus, the maximum value of the signal to be ultimately obtained is achieved. This is because, if the individual spin nuclei were to perform a precessional motion out of phase about the z-axis, the transversal component of the magnetization, being proportional to the ultimate measurement signal, would be substantially equal to zero. The magnetic field gradient $G_x^-$ and $G_z^\pm$ serve to dephase the spin nuclei in the x and z direction, respectively. Phase encoding is thus realized in the latter direction.

During the interval 3, bounded by the instants $t=t_b$ and $t=t_c$, a positive gradient $G_x^+$ is applied in order to rephase the spin nuclei in the x direction; these spin nuclei which will produce a spin echo in the plane $Y=Y_0$ at the instant at which the phase discrimination in the x direction terminates. This instant $(t=t_{e1})$ is found from the following equation, a spin echo condition:

$$\{Int(G_x^- dt)\}t_a \text{ to } t_b = \{Int(G_x^+ dt)\}t_b \text{ to } t_{e1} \quad (2)$$

After the instant $t=t_{e1}$, the spin nuclei are further dephased in the x direction by the gradient $G_x^+$. Because the magnetization M performs a precessional motion about the z-axis at an angle $\alpha°$, the resonance signal ultimately obtained will be proportional to the transversal component $M_t$ of the magnetization M. After some time, this transversal component $M_t$ will no longer be present because on the one hand the field gradient $G_x^+$ causes further dephasing and on the other hand the magnitude of the component $M_t$ is reduced by $T_2$ relaxation. The longitudinal component $M_l$ will meanwhile have increased due to $T_1$ relaxation.

After the instant $t=t_c$, the same cycle can be repeated, without observing a waiting period or by observing only a brief waiting period. A high-frequency electromagnetic pulse of the next cycle causes a precessional motion at an angle $\alpha°$ of the longitudinal component $M_l$ of the magnetization M which performs a precessional motion about the z-axis at an angle $\alpha°$ under the influence of the first angle $\alpha°$ pulse. The signal ultimately obtained is proportional to the transversal magnetization $M_t'$:

$$M_t' = M_l.\sin(\alpha) \quad (3)$$

The longitudinal magnetization $M_l'$ equals:

$$M_l' = M_l.\cos(\alpha) \quad (4)$$

During a next cycle, the component $M_l'$ is again rotated through an angle $\alpha$ by an $\alpha°$ pulse, and the signal ultimately obtained will be proportional to the transversal component of the component $M_l'$. The transversal component of the component $M_t'$ does not contribute to the measurement signal, because the field gradient $G_x^+$ causes further dephasing after the resonance signal so that prior to the start of a new cycle there will be no component present in the transversal (measurement) direction.

The magnetic field gradient $G_z^\pm$ serves to provide phase encoding in the z direction. This is because, when the field gradient $G_z^\pm$ is terminated at the instant $t=t_b$, nuclei in the z direction will have the same precessional frequency but a different precessional phase. The phase angle variation experienced by a nucleus in dependence of its position in the z direction will be proportional to the local intensity of the field gradient $G_z^\pm$. The sum of all spin vector contributions N of a column of nuclei in the z direction is proportional to a specific image frequency in the z direction at the area of the column nuclei. The magnitude of this sum is proportional to the magnitude of $G_z^\pm$.

By repeating the above cycle a number of times for different values of the field gradient $G_z^\pm$, a complete two-dimensional image of a selected slice in the z–x plane can be obtained.

It is definitely not necessary to start a new measurement cycle after the instant $t=t_c$. By inverting the gradient direction of a magnetic field gradient $G_x^+$ present during the measurement period $(t_b-t_c)$ during a subsequent measurement period, a second resonance signal can be generated and sampled at the instant $t=t_{e2}$.

Figure 2 shows a so-called $(\alpha°-T_R)_N$ pulse sequence, i.e. a sequence of N $\alpha°$ pulses which are successively generated at intervals $T_R$. When the magnetization M is directed along the z-axis for the first $\alpha°$ pulse and the transversal magnetization $M_t$ is substantially equal to zero just before each $\alpha°$ pulse due to dephasing and relaxation, the following relation holds good for the transversal magnetization $M_{tN}$ immediately after the $N^{th}$ $\alpha°$ pulse:

$$M_{tN} = M_{te} + (M_{to} - M_{te}).\exp(-N/N_\delta) \quad N>=0 \quad (5)$$

where

$$M_{to} = M.\sin(\alpha) \quad (6)$$

$$M_{te}=[M.\sin(\alpha).(1-\exp(-T_R/T_1))]/[1-\cos(\alpha).\exp(-T_R/T_1)] \quad (7)$$

$$N_\delta= 1/[T_R/T_1-\ln \cos (\alpha)] \quad (8)$$

in which $T_R$ is the repetition period, $T_1$ is the longitudinal relaxation time, $M_{to}$ is the transversal magnetization for $N=0$, and $M_{te}$ is a transversal equilibrium magnetization. As appears from equation (5), the transversal magnetization $M_{tN}$ tends towards a transversal equilibrium magnetization after N $\alpha°$ pulses. This effect is referred to as a "switch-on" effect.

## Claims

1. A method of determining a nuclear magnetization distribution in a region of a body which is situated in a generated, steady, uniform magnetic field, which method comprises measurement cycles including the steps a), b), c) and d)

   a) influencing spin nuclei in the selected region of the body by means of high-frequency electromagnetic pulses,

   b) applying a preparatory magnetic field gradient during a preparation period,

   c) rephasing the spin nuclei by means of a magnetic field gradient which has been inverted with respect to the magnetic field gradient applied during the preparation period,

   d) sampling the resonance signal during a measurement period

   e) repeating measurement cycles including the steps a), b), c) and d) each time with a different value of the time integral of the magnetic field gradient specified in paragraph b), characterized in that the high-frequency electromagnetic pulses are excitation pulses in the form of $\alpha^\circ$ pulses where $0<\alpha<90^\circ$, the successive measurement cycles being directly or substantially directly consecutive, and in that a longitudinal relaxation time $T_1$ per volume element is calculated from intensities of volume elements in images which differ either as regards the angle $\alpha$ and/or the repetition time $T_R$ between two successive $\alpha^\circ$ pulses.

2. A method as claimed Claim 1, characterized in that the longitudinal relaxation time $T_1$ is calculated by means of the formula:

$Ip=[c.\sin(\alpha).(1-\exp(-T_R/T_1))]/[1-\cos(\alpha).\exp(-T_R/T_1)]$, in which Ip is the intensity of a volume element p, $\alpha$ is the angle $\alpha^\circ$, $T_R$ is the repetition time, $T_1$ is the longitudinal relaxation time, and c is a constant which does not depend on $\alpha$, $T_R$ or $T_1$.

## Patentansprüche

1. Verfahren zur Bestimmung einer Verteilung der Kernspinmagnetisierung in einem Gebiet eines Körpers, der sich in einem erzeugten, statischen, homogenen Magnetfeld befindet, und dieses Verfahren enthält Zyklen mit den Schritten a), b), c) und d):

a) Beeinflussung von Spinkernen in ausgewählten Gebiet des Körpers mittels elektromagnetischer Hf-Impulse,

b) Anlegen eines vorbereitenden Magnetfeldgradienten in einer Vorbereitungszeit,

c) Rephasierung der Spinkerne mittels eines Magnetfeldgradienten, der in bezug auf den in der Vorbereitungszeit angelegten Magnetfeldgradienten umgekehrt ist,

d) Abtasten des Resonanzsignals in einer Meßzeit,

e) Wiederholung von Meßzyklen einschließlich der Schritte a), b), c) und d) jeweils mit einem abweichenden Wert des Zeitintegrals des unter b) spezifizierten Magnetfeldgradienten,

dadurch gekennzeichnet, daß die elektromagnetischen Hf-Impulse Erregungsimpulse in Form von $\alpha^\circ$ Impulsen sind, wobei $0<\alpha<90^\circ$ ist, und die nacheinander folgenden Meßzyklen direkt oder im wesentlichen direkt aufeinander folgen, und daß eine Längsrelaxationszeit $T_1$ je Volumenelement aus Intensitäten von Volumenelementen in Bildern errechnet wird, die sich entweder hinsichtlich des Winkels $\alpha$ und/oder der Wiederholungszeit $T_R$ zwischen zwei aufeinanderfolgenden $\alpha^\circ$ Impulsen unterscheiden.

2. Verfahren nach Anspruch 1, dadurch gekennzeichnet, daß die Längsrelaxationszeit $T_1$ mit der Formel

$Ip=[c.\sin(\alpha).(1-\exp(-T_R/T_1))]/[1-\cos(\alpha).\exp(-T_R/T_1)]$ berechnet wird, in der Ip die Intensität eines Volumenelements p, $\alpha$ der Winkel $\alpha^\circ$, $T_R$ die Wiederholungszeit, $T_1$ die Längsrelaxationszeit und c eine Konstante sind, die nicht von $\alpha$, $T_R$ oder $T_1$ abhängig ist.

## Revendications

1. Procédé pour déterminer une distribution de la magnétisation nucléaire dans une région d'un corps qui est située dans un champ magnétique uniforme constant généré, ce procédé comprenant des cycles de mesure impliquant les opérations a), b), c) et d) suivantes:

a) les spins nucléaires dans la région choisie du corps sont influencés au moyen d'impulsions électromagnétiques de haute fréquence;

b) un gradient de champ magnétique préparatoire est appliqué pendant une période de préparation;

c) la phase des spins nucléaires est rétablie au moyen d'un gradient de champ magnétique qui a été inversé par rapport au gradient de champ magnétique appliqué pendant la période de préparation;

d) le signal de résonance est échantillonné pendant une période de mesure;

e) les cycles de mesure impliquant les opérations a), b), c) et d) sont répétés chaque fois avec une valeur différente pour l'intégrale dans le temps du gradient de champ magnétique spécifié sous b);

caractérisé en ce que les impulsions électromagnétiques de haute fréquence sont des impulsions d'excitation sous la forme d'impulsions de $\alpha^\circ$ ou $0<\alpha<90^\circ$, les cycles de mesure successifs étant directement, ou quasi directement, consécutifs, et en ce qu'un temps de relaxation longitudinale $T_1$ par élément de volume est calculé à partir d'intensités d'éléments de volume dans des images qui diffèrent quant à l'angle $\alpha$ et/ou quant au temps de répétition $T_R$ entre deux impulsions de $\alpha^\circ$ successives.

2. Procédé suivant la revendication 1, caractérisé en ce que le temps de relaxation longitudinale $T_1$ est calculé au moyen de la formule:

$Ip=[c.\sin(\alpha).(1-\exp(-T_R/T_1))]/[1-\cos(\alpha).\exp(-T_R/T_1)]$

dans laquelle Ip est l'intensité d'un élément de volume p, $\alpha$ est l'angle de $\alpha^\circ$, $T_R$ est le temps de répétition, $T_1$ est le temps de relaxation longitudinale et c est une constante qui ne dépend pas de $\alpha$, de $T_R$ ou de $T_1$.

FIG.1

FIG. 2